# EUROPEAN PATENT APPLICATION

(11) **EP 4 776 762 A1**
(43) Date of publication of application: **15.07.2026**
(21) Application number: 25151750.4
(22) Date of filing: 14.01.2025
(51) Int. Cl.: H05K 1/18, H05K 3/00, H05K 1/02, H05K 3/42

(54) **COMPONENT CARRIER WITH COMPONENTS SHIELDED BY VERTICAL PARTITIONING STRUCTURES DISCONNECTED IN A SHIELDING REGION**

(71) Applicant: AT & S Austria Technologie & Systemtechnik Aktiengesellschaft, 8700 Leoben-Hinterberg (AT)
(72) Inventor: KIRCHHEIMER, Karl Philipp, 8700 Leoben (AT); OGGIONI, Stefano Sergio, 8700 Leoben (AT)
(74) Representative: Dilg, Haeusler, Schindelmann Patentanwaltsgesellschaft mbH

(57) **Abstract**

A component carrier (100), which comprises a stack (102) which comprises at least one electrically conductive layer structure (104-106) and at least one electrically insulating layer structure (108), at least two components (110, 112) arranged on and/or in the stack (102) side-by-side and divided by a space (114), and at least one electrically conductive first vertical partitioning structure (116) and at least one electrically conductive second vertical partitioning structure (118), wherein at least one of the vertical partitioning structures (116, 118) is arranged at least partially in said space (114) and wherein each of the vertical partitioning structures (116, 118), in a plan view on the stack (102), surrounds at least partially at least one assigned one of the at least two components (110, 112), wherein said at least one first vertical partitioning structure (116) and said at least one second vertical partitioning structure (118) interact with one of said at least one electrically conductive layer structure (104) for shielding the at least two components (110, 112) and are disconnected from each other in a shielding region (120) around said at least two components (110, 112).

## Description

The invention relates to a component carrier, and to a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

It is an object of the invention to provide an electrically reliable component carrier.

In order to achieve the object defined above, a component carrier and a method of manufacturing a component carrier according to the independent claims are provided.

According to an exemplary embodiment, a component carrier is provided which comprises a stack which comprises at least one electrically conductive layer structure and at least one electrically insulating layer structure, at least two components arranged on and/or in the stack side-by-side and divided by a space, and at least one electrically conductive first vertical (for instance along the stack thickness direction) partitioning structure and at least one electrically conductive second vertical (for instance along the stack thickness direction) partitioning structure, wherein at least one of the vertical partitioning structures is arranged at least partially in said space and wherein each of the vertical partitioning structures, in a plan view on the stack, surrounds at least partially at least one assigned one of the at least two components, wherein said at least one first vertical partitioning structure and said at least one second vertical partitioning structure interact with one of said at least one electrically conductive layer structure for shielding the at least two components and are disconnected from each other in a shielding region around said at least two components.

According to another exemplary embodiment of the invention, a method of manufacturing a component carrier is provided, wherein the method comprises providing a stack which comprises at least one electrically conductive layer structure and at least one electrically insulating layer structure, arranging at least two components on and/or in the stack side-by-side and divided by a space, forming at least one electrically conductive first vertical partitioning structure and at least one electrically conductive second vertical partitioning structure, wherein at least one of the vertical partitioning structures is arranged at least partially in said space, and wherein each of the vertical partitioning structures, in a plan view on the stack, surrounds at least partially at least one assigned one of the at least two components, and configuring said at least one first vertical partitioning structure and said at least one second vertical partitioning structure to interact with one of said at least one electrically conductive layer structure for shielding the at least two components, wherein said at least one first vertical partitioning structure and said at least one second vertical partitioning structure are disconnected from each other in a shielding region around said at least two components.

In the context of the present application, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, and an IC (integrated circuit) substrate. For example, a component carrier may be a rigid-flex carrier, or a flexible substrate. A component carrier may also be a hybrid board combining different ones of the above-mentioned types of component carriers. In particular, a component carrier may comprise a stack comprising a plurality of electrically conductive layer structures and/or electrically insulating layer structures.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures, which preferably may be arranged in a parallel manner, by the application of mechanical pressure and/or heat.

In the context of the present application, the term "layer structure" may particularly denote a continuous layer, a patterned layer or a plurality of nonconsecutive islands within a common plane.

In the context of the present application, the term "component" may particularly denote a functional body configured for providing a function in the context of the component carrier. More specifically, such a component may be an electronic component providing an electronic functionality during operation of the component carrier. For instance, the component may be a semiconductor chip having at least one monolithically integrated circuit element. Preferably, the component is an electromagnetic component processing and/or transmitting electromagnetic radiation, in particular a radio frequency radiation, during operation. For instance, the respective component may emit and/or receive electromagnetic radiation, such as radio frequency radiation, during operation. It may also be possible that the component is sensitive to electromagnetic radiation in its environment. For instance, operation of the component may be disturbed by electromagnetic radiation, such as radio frequency radiation, in its environment.

In the context of the present application, the term "space dividing components arranged side-by-side" may particularly denote a spatial volume between (in particular completely or partially) laterally juxtaposed components keeping said components apart from each other, in particular preventing a direct physical contact between said components. In particular, said space may be partially filled with material of the stack, in particular with material of its at least one electrically insulating layer structure. In an example, the material of the stack at least partially filling the space may have a dielectric constant in the range from 1.5 to 30, in particular in the range from 1.7 to 15.

In the context of the present application, the term "electrically conductive vertical partitioning structure" may particularly denote an electrically conductive structure comprising one or a plurality of electrically conductive elements or sub-structures extending completely or predominantly along a direction perpendicular to the main surfaces of the stack. For instance, a deviation of elements or sub-structures of said partitioning structure from a purely vertical extension may be in an angular range of ±20°, in particular ±10°, around a vertical axis. In particular, the respective partitioning structure may be made of a metallic and/or a magnetic material. The electrically conductive material of a respective partitioning structure may be configured for shielding at least one of said components with respect to electromagnetic radiation. For example, a partitioning structure may comprise or consist of metallic vias (in particular laser vias or mechanically drilled vias filled partially or entirely with metallic material), metallic posts or pillars, and/or metallic elongated (i.e. from in a plan view), for example sheet-like, structures. For instance, a respective partitioning structure may comprise an array of vertically extending metallic sub-structures partially or entirely surrounding a respective component, in particular with spaces in between different sub-structures of the partitioning structure.

In the context of the present application, the term "plan view of the stack" may particularly denote a viewing direction perpendicular to a main surface of the stack. For example, said viewing direction may be along an extension direction of sub-structures of the respective vertical partitioning structure. Such a viewing direction may be parallel to a stacking direction of the layer structures of the stack.

In the context of the present application, the term "vertical partitioning structure at least partially surrounding a component" may particularly denote a configuration of the respective vertical partitioning structure according to which it is located along at least part of a perimeter or circumference specifically of the assigned component. For instance, the vertical partitioning structure may surround the component entirely or along at least one side.

In the context of the present application, the term "vertical partitioning structure interacting with an electrically conductive layer structure for shielding components" may particularly denote an arrangement of vertical partitioning structure and electrically conductive layer structure so that this arrangement partially or entirely shields a respective component spatially delimited by said arrangement with respect to a surrounding of said arrangement. In particular, said shielding may be a shielding with respect to electromagnetic radiation. More specifically, said shielding may eliminate or inhibit propagation of electromagnetic radiation, in particular radio frequency radiation, from the respective component(s) towards an exterior of the arrangement and/or from an exterior of the arrangement to the respective component(s). In particular, said arrangement may reduce electromagnetic interference (EMI) with respect to said component. Electromagnetic interference, in particular radio-frequency interference related to the radio frequency spectrum, may denote a disturbance generated by an external source that affects an electrical circuit by electromagnetic induction, electrostatic coupling and/or conduction. For instance, said arrangement may form a Faraday cage (or a part thereof) around the respective component to which both the vertical partitioning structure and the electrically conductive layer structure may contribute. The first and second vertical partitioning structures, in particular in combination with at least one of the at least one electrically conductive layer structure of the stack, may form an electrically conductive shielding structure. Such a shielding structure may particularly denote a physical structure comprising an electrically conductive material (such as a metal, for example copper) and being located and configured so as to be capable of suppressing electromagnetic interference which may otherwise result in crosstalk between different active portions of the multiple components.

In the context of the present application, the term "vertical partitioning structures disconnected from each other in a shielding region around said at least two components" may particularly denote a configuration according to which in a spatial region in which the vertical partitioning structures contribute to a shielding of the components, in particular with respect to electromagnetic radiation such as radio frequency waves, the first vertical partitioning structure and the second vertical partitioning structure are mechanically and/or electrically decoupled from each other. Optionally, the first vertical partitioning structure and the second vertical partitioning structure may be mechanically and/or electrically coupled at a location outside of or apart from such a shielding region, for instance by an electrically conductive layer structure at an exterior main surface of the stack or at a ground line. However, in the shielding region which may include at least part of the space dividing the components arranged side-by-side, the first and second vertical partitioning structures may be unconnected and/or electrically decoupled from each other. It may also be possible that said at least one first vertical partitioning structure and said at least one second vertical partitioning structure are disconnected from each other in the entire component carrier (in particular not only in the shielding region around said at least two components, but completely).

In the context of the present application, the term "main surface" of a body may particularly denote one of two largest opposing surfaces of the body or outermost opposing surfaces of the body. The main surfaces may be connected by circumferential side walls. The thickness of a body, such as the component carrier or the stack, may be defined by the distance between the two opposing main surfaces.

According to an exemplary embodiment, a component carrier (such as a printed circuit board or an integrated circuit substrate) may comprise a layer stack (such as a laminate). Said stack may be made of one or more electrically conductive layer structure and one or more electrically insulating layer structures. Two components (such as semiconductor chips, for instance at least one of which having a radiofrequency functionality and/or sensitivity) may be surface mounted on and/or embedded in the stack so as to be located side-by-side (for instance, but not necessarily, at the same vertical level). The components may be divided or separated by a space or a spatial region in between. A first vertical partitioning structure and a second vertical partitioning structure may comprise an electrically conductive material (such as a metal, for instance copper). At least part of one or both of said vertical partitioning structures may be located in the space between the components for decoupling or shielding the components from each other where closest together, in particular with respect to radiofrequency waves. A respective one of the vertical partitioning structures may laterally extend around an assigned one of the components or part thereof. The vertical partitioning structures may functionally and/or structurally interact (for instance may be electrically and mechanically coupled) with one or more electrically conductive layer structures of the stack so as to shield the components (for instance in the fashion of a Faraday cage). For instance, said shielding may be a suppression of electromagnetic interference (EMI), an inhibition of crosstalk between the components, a reduction of the exposure of an electronic periphery of the component(s) to electromagnetic stray radiation from the component(s) and/or a reduction of the exposure of the respective component(s) to electromagnetic stray radiation. Beneficially, the first vertical partitioning structure and the second vertical partitioning structure may be functionally and/or structurally disconnected from each other at least in a shielding region in which the components experience said shielding function of the vertical partitioning structures, in particular in the above mentioned space. This has advantages: During operation of the component carrier, the component(s) (and/or other devices of the component carrier and/or an electronic periphery of the component carrier) can inject noise in the component carrier, for instance in an electrically conductive structure providing an electric reference potential (such as a ground line). If not disconnected in the shielding region, the first and second vertical partitioning structures (which may for instance be assigned to an analog domain and a digital domain, respectively) might be mutually disturbed by such and/or other noise. When the first and second vertical partitioning structures are disconnected in the shielding region (which may for instance be a region at least part of which encompassing at least part of a Faraday cage region) there may be less noise and/or less crosstalk. Consequently, propagation of electric signals in the component carrier may be carried out with less noise and less crosstalk, thus with a better signal integrity.

In the following, further exemplary embodiments of the component carrier and the method will be explained.

In an embodiment, the vertical partitioning structures, in particular in combination with at least one electrically conductive layer structure of the stack, may form an electromagnetic interference protection arrangement for the components. In the context of the present application, the term "electromagnetic interference protection arrangement" may particularly denote a metallic and/or magnetic structure suppressing a disturbance generated by a respective component and/or an external source that affects one of the components by electromagnetic induction, electrostatic or electromagnetic coupling, and/or conduction. The disturbance may degrade the performance of at least one of the components or may even stop it from functioning. Such an electromagnetic interference protection arrangement may also suppress crosstalk between the components. In the context of the present application, the term "crosstalk" may refer to a phenomenon of electromagnetic interference caused by the electric or magnetic fields of a signal affecting another signal in an adjacent circuit. Essentially, an electrical signal may have a varying electromagnetic field. Whenever electromagnetic fields overlap, unwanted signals - capacitive, conductive and/or inductive coupling - may cause electromagnetic interference (EMI) that can create crosstalk. Overlap can occur with structured cabling, integrated circuit design, audio electronics and other connectivity systems. For example, if there are two wires in close proximity that are carrying different signals, their currents may create magnetic fields that induce a weaker signal in the neighboring wire, therefore the crosstalk may occur in the component(s). Crosstalk is a big concern for electrical product development because of the demand for electronic systems to increase in bandwidth and decrease in size. This puts high-speed circuitry and high-bandwidth channels in proximity. Additionally, the continuous increase in internal clock frequencies (for example 5 to 10 GHz) and the increase in data rates (for example above 10 Gbps) are also fueling the emergence of crosstalk issues. Therefore, an effective electrically conductive shielding structure plays a vital role on the component carrier, in particular on a component carrier for HF (high-frequency) applications.

The first and second vertical partitioning structures, in particular in combination with an electrically conductive layer structure of the stack, may shield the components from high-frequency radiation. In particular, at least one of the components may fulfill a high-frequency application. In the context of the present application, the term "high-frequency application" may particularly denote an electronic function related to a task which may involve the processing and/or communication (i.e. transmission and/or receiving) of a high-frequency or radio frequency signal. Such a radio or high-frequency signal may be an electric or electromagnetic signal propagating along the component carrier or between the component carrier and an electronic periphery in a range of frequencies used for communications or other signals. In particular, a radio frequency (RF) signal may for example have a frequency in the range between 3 kHz and 300 GHz, in particular in a range from 1 GHz to 150 GHz. For providing a high frequency application, the respective component may be equipped with at least one high-frequency active portion which may have integrated functionality in terms of high-frequency signal generation and/or high-frequency signal processing and/or high-frequency signal transmission. For example, a high-frequency component may be a semiconductor chip or an active portion (such as an RFIC, radiofrequency integrated circuit) configured for operating with high-frequency signals. For instance, the high-frequency component or active portion may provide front end functionality for carrying out front end processing tasks of a high frequency application, in particular a communications application. Additionally or alternatively, it is possible that a high-frequency component or active portion functions for impedance matching to ensure a matching of impedances of a front end and of a coupling element. Additionally or alternatively, other functions of a high-frequency component or active portion are possible.

In an embodiment, one of the at least two components is arranged in a first cavity of the stack, and another of the at least two components is arranged in a second cavity of the stack, wherein in particular said space comprises electrically insulating material of the stack between the first cavity and the second cavity. Cavities may be created in a surface portion of the stack. One or more respective components can be embedded in a respective cavity. For example, at least part of the material between the cavities does not affect the effect of the partitioning structures.

In an embodiment, the first cavity and the second cavity are formed in at least one common of said layer structures of the stack. For example, the cavities may be at the same height level or may extend over the same vertical range. Alternatively, the cavities may be mutually displaced in height direction. They may however have an overlapping spatial range in the vertical direction.

In an embodiment, a plurality of said components is arranged at one side of the space, in particular in the first cavity and/or a plurality of said components is arranged at the opposed side of the space, in particular in the second cavity. Thus, groups of components may be formed in any of the cavities. Components of one group may have a common property. Components of different groups may differ concerning at least one property. For instance, components may be grouped in cavities concerning an electrical domain to which a respective component or cavity belongs. For example, digital components may be inserted in one cavity, and analog components may be inserted in another cavity. This may allow to spatially and functionally separate different electrical domains and their components. Different groups of components in different cavities may be mutually shielded by the vertical partitioning structures, in particular by their sub-structures in the space between the cavities. It may also be possible to mutually shield components of a common group with respect to each other. This may be accomplished by metallic shielding walls, metallic shielding pillars, etc. in or adjacent to the cavity and between the components.

In an embodiment, the at least one first vertical partitioning structure and the at least one second vertical partitioning structure are embedded in the stack. Thus, the vertical partitioning structures may be located inside of the stack, partially or entirely. This may lead to a highly compact design and an EMI protection spatially very close to the components.

In an embodiment, the at least two components are embedded in the stack. This may reduce the space consumption of the component carrier. In another embodiment, the at least two components are arranged on a common surface on the stack. Thus, the components may also be surface mounted. It may also be possible that the component carrier comprises at least one embedded component and at least one surface mounted component.

In an embodiment, the at least one first vertical partitioning structure and the at least one second vertical partitioning structure are arranged, partially or entirely, on the common surface. Hence, the vertical partitioning structures may be located on top of the stack, partially or entirely.

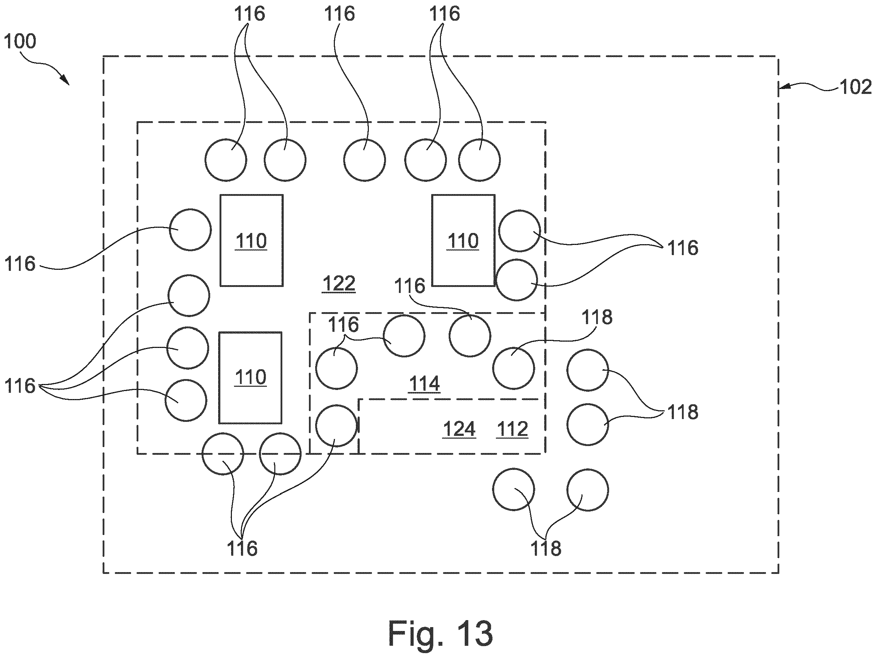

In an embodiment, at least one cavity and/or the space between two cavities may have an L shape or an L like shape. Such an embodiment is shown for instance in Figure 13. There is a high flexibility concerning cavity design.

In an embodiment, a plurality of said at least two components is arranged on the same side of said space. Thus, components having a common property, such as a common functional property (for instance an analog electronic property or a digital electronic property) may be grouped also spatially. This may allow to spatially separate components of different properties, such as different functional properties, for instance by inserting them in different cavities of the stack. This spatial separation, in particular in combination with the vertical partitioning structures, may also allow to shield the components of different groups with respect to each other, so as to protect them from electromagnetic crosstalk or stray radiation. The specific needs of components assigned to a specific electrical domain may thus be met.

In an embodiment, the at least one first vertical partitioning structure and/or the at least one second vertical partitioning structure extends through the space and/or besides a respective one of the at least two components. The space between the different components can be considered as a critical region concerning electromagnetic interference between the components due to the close vicinity of said components in said space. Thus, arranging at least part of the vertical partitioning structures exactly there may suppress crosstalk and parasitic effects caused by electromagnetic stray radiation highly efficiently.

In an embodiment, at least part of the at least one first vertical partitioning structure and/or at least part of the at least one second vertical partitioning structure comprises at least one blind hole, through hole and/or via, in particular filled at least partially with a metallic and/or a magnetic material. Such holes or empty volumes in the stack may be formed during the manufacture of the component carrier for example by mechanically drilling, laser drilling and/or etching. Thereafter, such holes or empty volumes may be served with a metallic material by plating, for instance electroless plating and/or electroplating. Consequently, sub-structures of the vertical partitioning structures in the form of pads, pillars and/or frustoconical structures may be obtained.

In an embodiment, at least part of the at least one first vertical partitioning structure and/or at least part of the at least one second vertical partitioning structure comprises at least one wall section or through wall, in particular filled at least partially with a metallic and/or a magnetic material. For instance, such wall sections or through walls may extend vertically and/or slanted. Together with horizontal electrically conductive layer structures of the stack, they may protect components from all six sides with respect to electromagnetic radiation. For example, trenches may be formed in the stack and may then be filled with metallic material. For instance, trench formation may be accomplished by laser processing, mechanical processing and/or etching. Thereafter, the trenches may be filled with metallic material by plating or by inserting metallic paste. The trench may have an hourglass-shape from a side view, if it is formed by drilling from top and bottom surfaces.

In an embodiment, at least part of the at least one first vertical partitioning structure and/or at least part of the at least one second vertical partitioning structure comprises a vertical electrode and/or a pillar. For instance, such a vertical electrode or pillar may have a cylindrical shape.

In an embodiment, at least part of the at least one first vertical partitioning structure and/or at least part of the at least one second vertical partitioning structure has a regular shape, an irregular shape, a round shape, a polygonal shape, and/or an elongated planar shape. There is a high design of freedom concerning the construction of the sub-structures of the vertical partitioning structures for a component carrier designer. The arrangement of said sub-structures may be done in accordance with a specific application.

In an embodiment, each of the at least one first vertical partitioning structure and the at least one second vertical partitioning structure comprises a continuous wall or a discontinuous wall. For instance, metal pillars surrounding a respective component or component group like a fence may form a discontinuous wall which however efficiently protects the surrounded component against electromagnetic radiation. Planar horizontal sections of the electrically conductive layer structures of the stack may be continuous walls providing EMI protection from above and/or below. A respective metallic wall may comprise one or more perforations through which electrically decoupled horizontal or vertical wiring structures may be guided, for instance for signal transmission from an/or to a component inside of said walls.

In an embodiment, the at least one first vertical partitioning structure and/or the at least one second vertical partitioning structure comprises multiple sub-structures connected with each other, in particular connected by the one of the at least one electrically conductive layer structure. For instance, multiple holes and/or vias filled with a metallic and/or magnetic material may be provided for this purpose.

In an embodiment, the at least one first vertical partitioning structure and/or the at least one second vertical partitioning structure completely surrounds a respective one of the at least two components. For instance, a Faraday cage for an individual component may be formed. Each vertical partitioning structure may be a separate structure (for instance a single plated through hole). Alternatively, each partitioning structure may be considered as a connection of a plurality of separate structures.

In an embodiment, the at least one first vertical partitioning structure and/or the at least one second vertical partitioning structure completely surrounds all of at least two of said at least two components arranged at the same side of the space, in particular all said components being arranged in a common cavity. For example, a Faraday cage for multiple components may be formed. Said Faraday cage may thus enclose a plurality of components.

In an embodiment, the at least one first vertical partitioning structure and/or the at least one second vertical partitioning structure only partially surrounds a respective one of the at least two components. For instance, the respective vertical partitioning structure may surround the respective component along less than four sides, for instance along only one side or along only three sides. This may lead to a simple construction of the vertical partitioning structure, in particular when a component only requires shielding in a certain direction or with respect to a certain spatial range.

In an embodiment, the at least one first vertical partitioning structure and/or the at least one second vertical partitioning structure only partially surrounds all of at least two of said at least two components arranged at the same side of the space, in particular all said components being arranged in a common cavity. For instance, the respective vertical partitioning structure may surround the entirety of components assigned to a specific cavity along less than four sides, for instance along only one side or along only three sides. This may lead to a simple construction of the vertical partitioning structure, in particular when a group of cavity-related components only requires shielding in a certain direction or with respect to a certain spatial range.

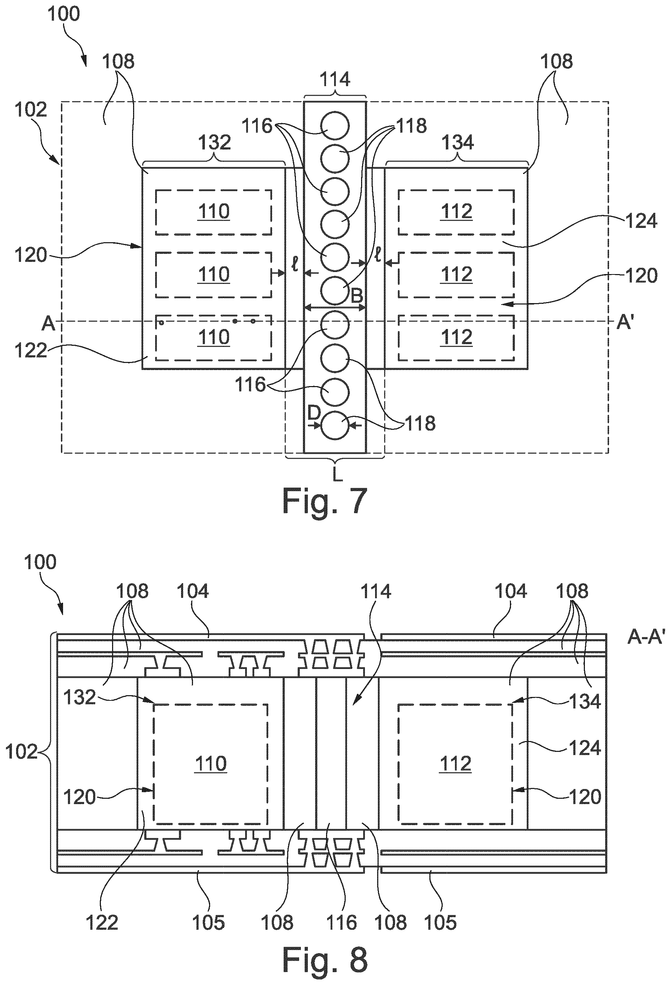

In an embodiment, at least some of sub-structures of the at least one first vertical partitioning structure are alternatively positioned (for example in a plan view on the stack) between at least some of sub-structures of the at least one second vertical partitioning structure. Such an embodiment is shown for instance in Figure 7. An alternating arrangement of sub-structures of the first vertical partitioning structure and sub-structures of the second vertical partitioning structure may render the component carrier compact without compromising on EMI protection.

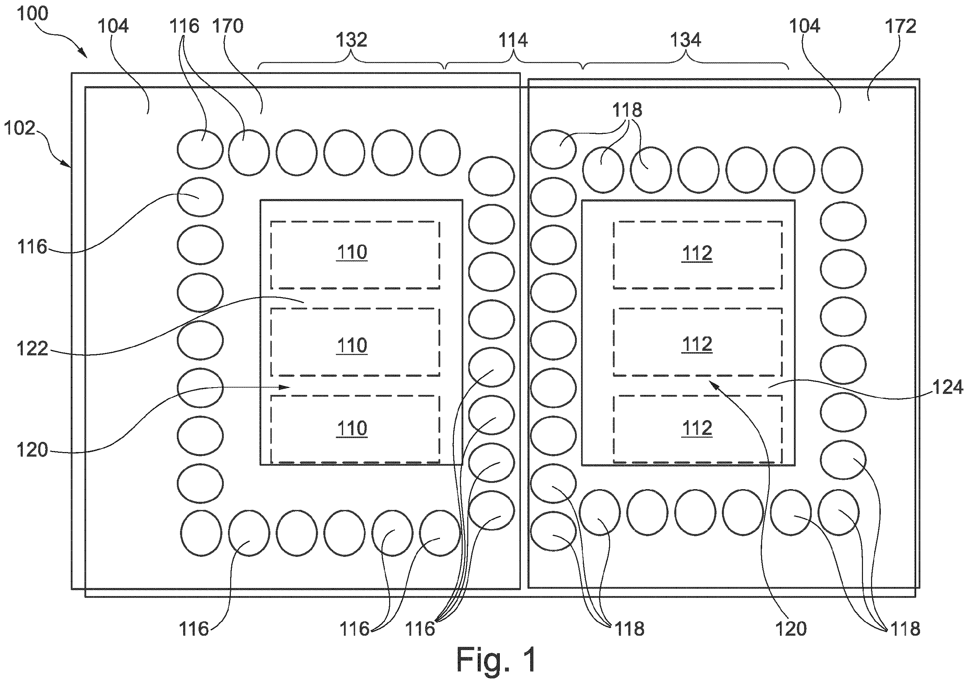

In an embodiment, at least some of sub-structures of the at least one first vertical partitioning structure are arranged along a first linear pattern and at least some of sub-structures of the at least one second vertical partitioning structure are arranged along a second linear pattern, in particular said first linear pattern extending along a direction parallel to a direction along which the second linear pattern extends. Such an embodiment is shown for instance in Figure 1. For example, two linear patterns or arrays of sub-structures of the respective vertical partitioning structures may be arranged parallel to each other at least partially in said space between the components.

In an embodiment, said first linear pattern and/or said second linear pattern defines a matrix of sub-structures. For instance, such a matrix may have a plurality (in particular at least 5, or at least 10) of rows and two columns.

In an embodiment, sub-structures of the at least one first vertical partitioning structure are arranged at one side of said space, in particular extending along at least one side of at least one of the at least two components on said side of said space. For instance, the sub-structures of the first vertical partitioning structure may be arranged only along one side of one or more components in a first cavity. It may also be possible that the sub-structures of the first vertical partitioning structure may be arranged along plural (for example four) sides of one or more components in the first cavity.

In an embodiment, sub-structures of the at least one second vertical partitioning structure are arranged at another side of said space, in particular extending along at least one side of at least one other of the at least two components on said other side of said space. For instance, the sub-structures of the second vertical partitioning structure may be arranged only along one side of one or more components in a second cavity. It may also be possible that the sub-structures of the second vertical partitioning structure may be arranged along plural (for example four) sides of one or more components in the second cavity.

In an embodiment, a part of the one of the at least one electrically conductive layer structure connecting sub-structures of the at least one first vertical partitioning structure and a part of the one of the at least one electrically conductive layer structure connecting sub-structures of the at least one second vertical partitioning structure extend along the same vertical level in the stack. Said parts may relate to a common planar metal layer, which may be patterned accordingly. This may simplify the manufacturing process, since the electrically conductive layer structure connecting sub-structures of the at least one first vertical partitioning structure and the electrically conductive layer structure connecting sub-structures of the at least one second vertical partitioning structure may be processed within the same manufacturing process step or stage.

In an embodiment, a part of the one of the at least one electrically conductive layer structure connecting sub-structures of the first vertical partitioning structure extends above, preferably continuously, at least one of the at least two components. Said part may protect the component(s) vertically, whereas the corresponding vertical partitioning structure protects said at least one component laterally.

In an embodiment, a part of the one of the at least one electrically conductive layer structure connecting sub-structures of the second vertical partitioning structure extends above, preferably continuously, at least one of the at least two components. Said part may protect the component(s) vertically, whereas the corresponding vertical partitioning structure protects said at least one component laterally.

In an embodiment, another one of said at least one electrically conductive layer structure is connected to the at least one first vertical partitioning structure on a vertically opposing side than said one of the at least one electrically conductive layer structure, so that at least one of the at least two components is shielded from above and below (preferably continuously) by said one of said at least one electrically conductive layer structure and said other one of said at least one electrically conductive layer structure, respectively. Thus, a closed Faraday cage portion may be formed by the upper and lower parts of electrically conductive layer structures and a fence-like Faraday cage portion may be formed by the corresponding first vertical partitioning structure.

In an embodiment, said other one of said at least one electrically conductive layer structure is connected to the at least one second vertical partitioning structure on the vertically opposing side than said one of the at least one electrically conductive layer structure, so that at least one other of the at least two components is shielded from above and below (preferably continuously) by said one of said at least one electrically conductive layer structure and said other one of said at least one electrically conductive layer structure, respectively. Thus, a closed Faraday cage portion may be formed by the upper and lower parts of electrically conductive layer structures and a fence-like Faraday cage portion may be formed by the corresponding second vertical partitioning structure.

In an embodiment, a part of said one of the at least one electrically conductive layer structure connecting the at least one first vertical partitioning structure is planarly misaligned with respect to another part of said one of the at least one electrically conductive layer structure connecting the at least one second vertical partitioning structure. Such a misalignment may occur during manufacture.

In an embodiment, a part of said one of the at least one electrically conductive layer structure connecting the at least one first vertical partitioning structure has a different planar extension with respect to another part of said one of the at least one electrically conductive layer structure connecting the at least one second vertical partitioning structure. Said different planar extensions or area values may reflect different dimensions and/or different numbers of the components in the various cavities, etc.

In an embodiment, the at least one first vertical partitioning structure and the at least one second vertical partitioning structure are disconnected from each other at a vertical extension of the at least one first vertical partitioning structure and/or the at least one second vertical partitioning structure. In a shielding region which may encompass the entire vertical extension of the partitioning structures (in particular its vertical metallic pillars), said disconnection may be established for preventing crosstalk of noise between them in this critical region.

In an embodiment, the first and second vertical partitioning structures are disconnected with respect to each other over the entire component carrier.

In another embodiment, the at least one first vertical partitioning structure and the at least one second vertical partitioning structure are connected with each other through at least one further of the at least one electrically conductive layer structure outside a region defined by the at least one first vertical partitioning structure and/or the at least one second vertical partitioning structure and said one of said at least one electrically conductive layer structure (and in particular said other one of said at least one electrically conductive layer structure). Outside of the shielding region, a connection may be optionally established, for instance to bring different regions to the same reference potential (for instance a ground potential).

In an embodiment, the at least one first vertical partitioning structure and/or the at least one second vertical partitioning structure comprises an electrically conductive pad at one or at both vertical extremities. Such a pad may simplify a connection of metal pillars to metallic planes.

In an embodiment, each of sub-structures of the at least one first vertical partitioning structure and/or the at least one second vertical partitioning structure comprises an electrically conductive pad at one or at both vertical extremities. Thus, a connection of a metal pillar at both opposing ends may be rendered more reliably.

In an embodiment, said one of the at least one electrically conductive layer structure is connected to said at least one pad, in particular by at least one electrically conductive via. Such a via, for instance formed by laser processing, may be embodied as a frustoconical structure filled with a metallic material, for instance by plating.

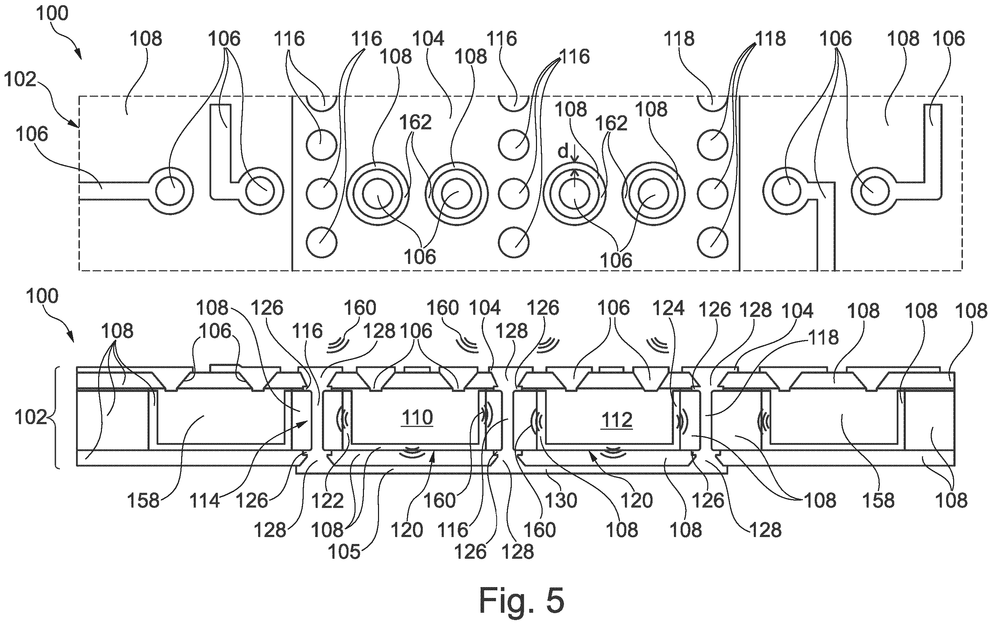

In an embodiment, a plurality of first vertical partitioning structures and/or a plurality of second vertical partitioning structures are connected at one or both extremities by an electrically conductive coupling structure, in particular having a loop shape. In particular, the loop shaped coupling structure is connected to said one of said at least one electrically conductive layer structure interacting with the at least one first vertical partitioning structure and/or the at least one second vertical partitioning structure, in particular through vias. Such an embodiment is shown for instance in Figure 5. In an example, the loop shape may comprise at least part of an electrically conductive layer structure. This may simplify the creation of a full or fully surrounding Faraday cage.

In an embodiment, the at least two components are connected to an additional one of said at least one electrically conductive layer structure, said additional electrically conductive layer structure being arranged vertically between the respective one of said at least two components and said one of the at least one electrically conductive layer structure interacting with the at least one first vertical partitioning structure or the at least one second vertical partitioning structure and/or spaced from said one of the at least one electrically conductive layer structure interacting with the at least one first vertical partitioning structure or the at least one second vertical partitioning structure. Such a configuration may allow to guide electric signals and/or power through the Faraday cage to the components without compromising on shielding. The signals and/or this power may be electrically decoupled from the components of the Faraday cage.

In an embodiment, the additional electrically conductive layer structure is not connected to said one of the at least one electrically conductive layer structure. This allows to keep the various layer structures at different electric potentials, for instance for transporting electric signals along well-defined paths without distortion.

In an embodiment, said at least one first vertical partitioning structure is associated to a first electrical domain and said at least one second vertical partitioning structure is associated to another second electrical domain. Different electrical domains of a component carrier and/or its components may have different electronic requirements and/or may need to be kept separately from each other, for instance for avoiding undesired phenomena such as crosstalk. With the described architecture, it may be possible to avoid undesired cross coupling of the different electrical domains, in particular what concerns electromagnetic radiation occurring in the different electrical domains. For instance, it may be desired to keep a digital domain separate from an analog domain, or a power supply domain separate from a signal transmission domain.

In an embodiment, at least one, in particular a plurality, of said at least two components on one side of said space is associated to the first electrical domain and/or at least one other, in particular another plurality, of said at least two components on the other side of said space is associated to the second electrical domain. Components assigned to a respective electrical domain may be grouped not only functionally, but also spatially.

In an embodiment, the one of the at least one first vertical partitioning structure and the at least one second vertical partitioning structure which is located closer to a respective one of the at least two components is associated to the same electrical domain as said respective component. Spatial vicinity of one or more components and a respective vertical partitioning structure may lead to a corresponding assignment to an electrical domain. For instance, a vertical partitioning structure may be grounded, but may be located closer to the component(s) belonging to the specific domain. Correspondingly, a respective part of said one of the at least one electrically conductive layer structure which is located closer to a respective one of the at least two components may be associated to the same electrical domain as said respective component.

In an embodiment, the first electrical domain is a digital domain and the second electrical domain is an analog domain. In particular, the at least one component of the digital domain may be configured for executing digital signal processing and/or transmission. In contrast to this, the at least one component of the analog domain may be configured for executing analog signal processing and/or transmission. Additionally or alternatively, the first electrical domain is a power domain and the second electrical domain is a signal domain. A power domain may provide electric power to a component. A signal domain may transmit electric signals to and/or from a component.

In an embodiment, each of the vertical partitioning structures, in a plan view on the stack, surrounds at least partially and separately at least one assigned one of the at least two components. Such an embodiment is shown for instance in Figure 1 and Figure 2. In the embodiment of Figure 7, for instance, the first and second vertical partitioning structures together partially surround all components rather than separately.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB or being plugged in a socket mounted on a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocy-clobutene (BCB) and/or a combination thereof. Reinforcing layer structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These pre-pregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium, molybdenum and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectrome-chanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a transparent plan view of a component carrier according to an exemplary embodiment of the invention.

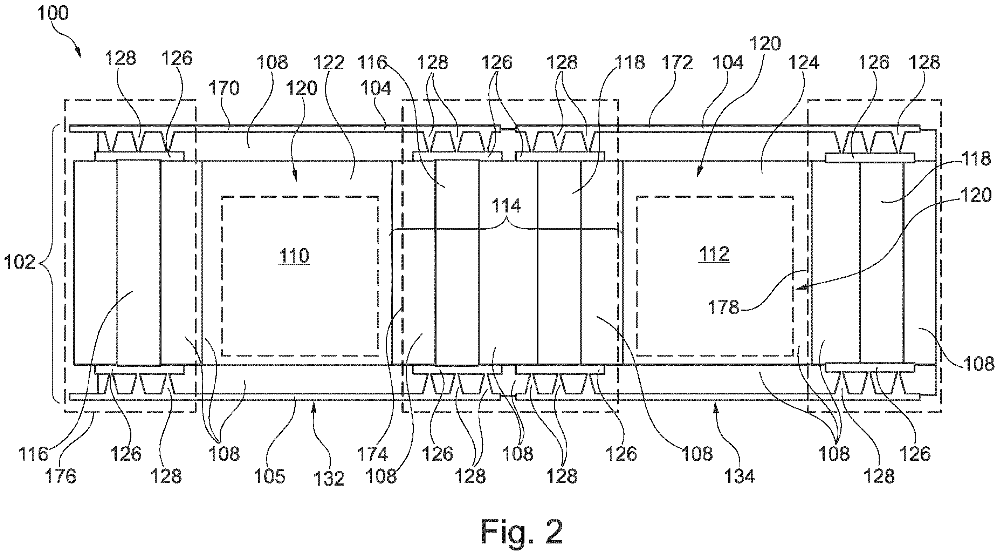

Figure 2 illustrates a cross-sectional view of the component carrier according to Figure 1.

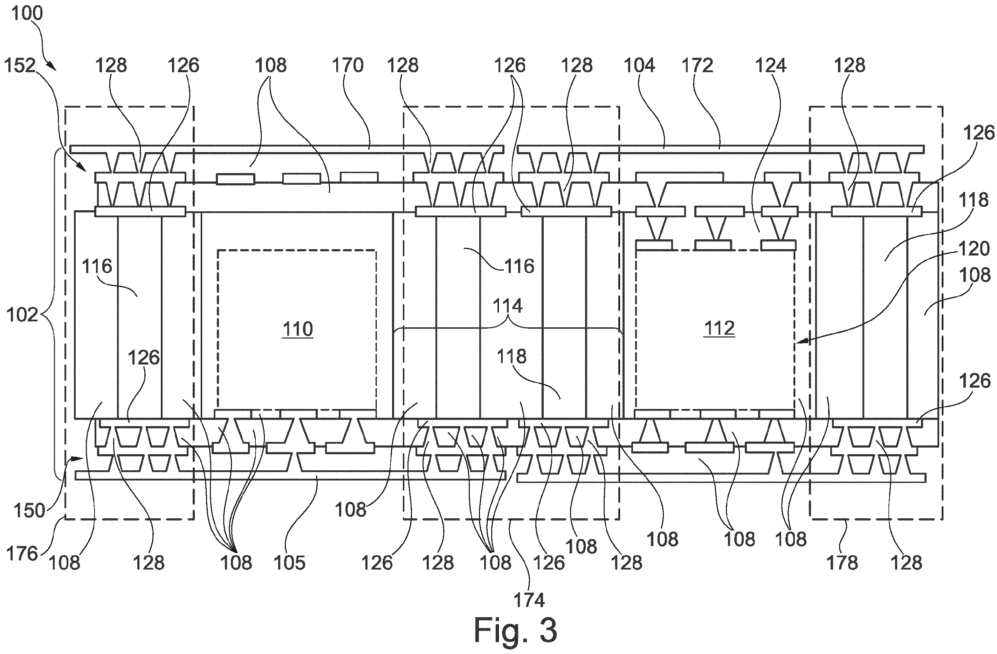

Figure 3 illustrates a cross-sectional view of a component carrier according to an exemplary embodiment of the invention similar to that according to Figure 1.

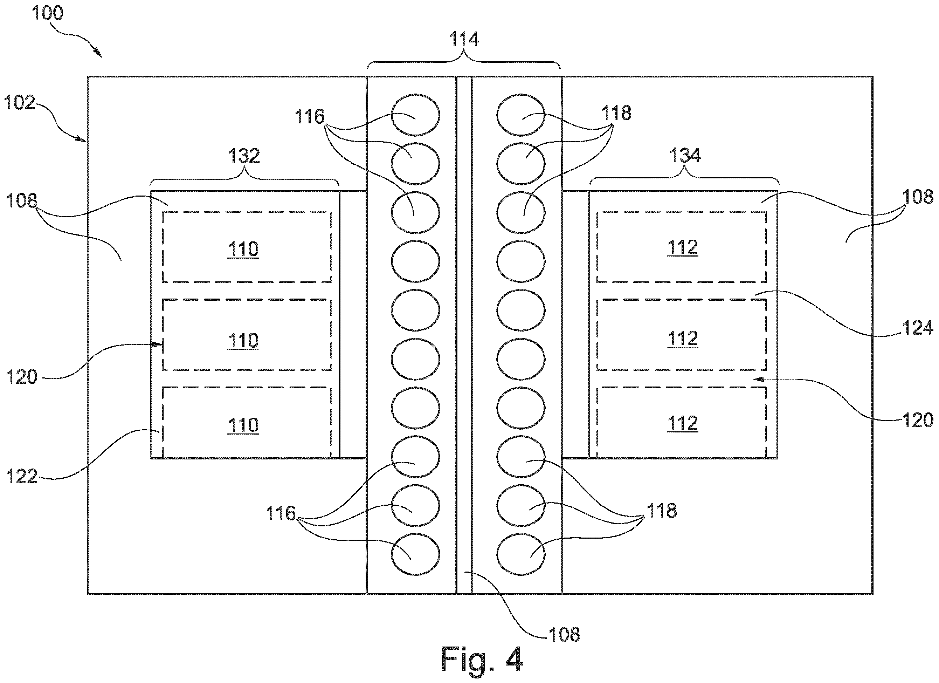

Figure 4 illustrates a transparent plan view of a component carrier according to another exemplary embodiment of the invention.
Figure 5 illustrates a plan view and a cross-sectional view of a component carrier according to another exemplary embodiment of the invention.

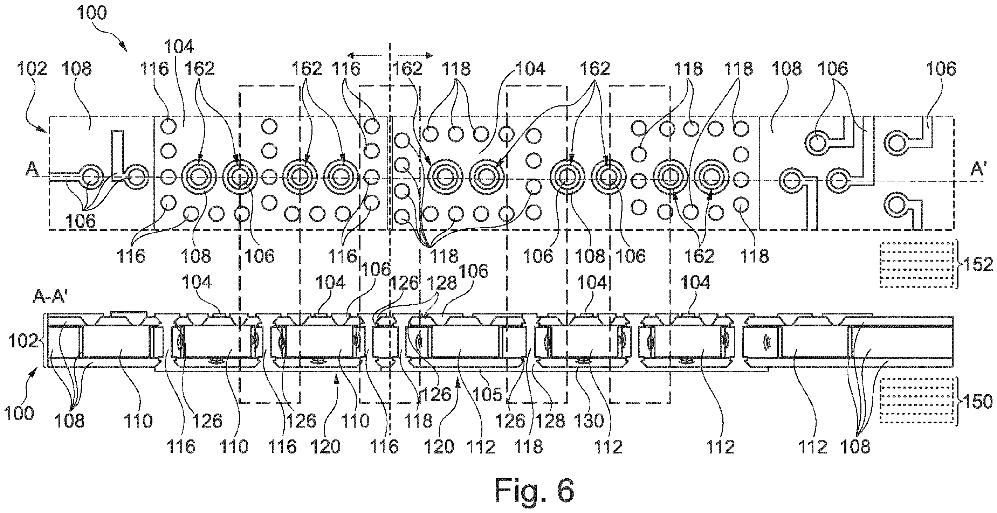

Figure 6 illustrates a plan view and a cross-sectional view of a component carrier according to another exemplary embodiment of the invention.
Figure 7 illustrates a transparent plan view of a component carrier according to another exemplary embodiment of the invention.
Figure 8 illustrates a cross-sectional view of the component carrier according to Figure 7.

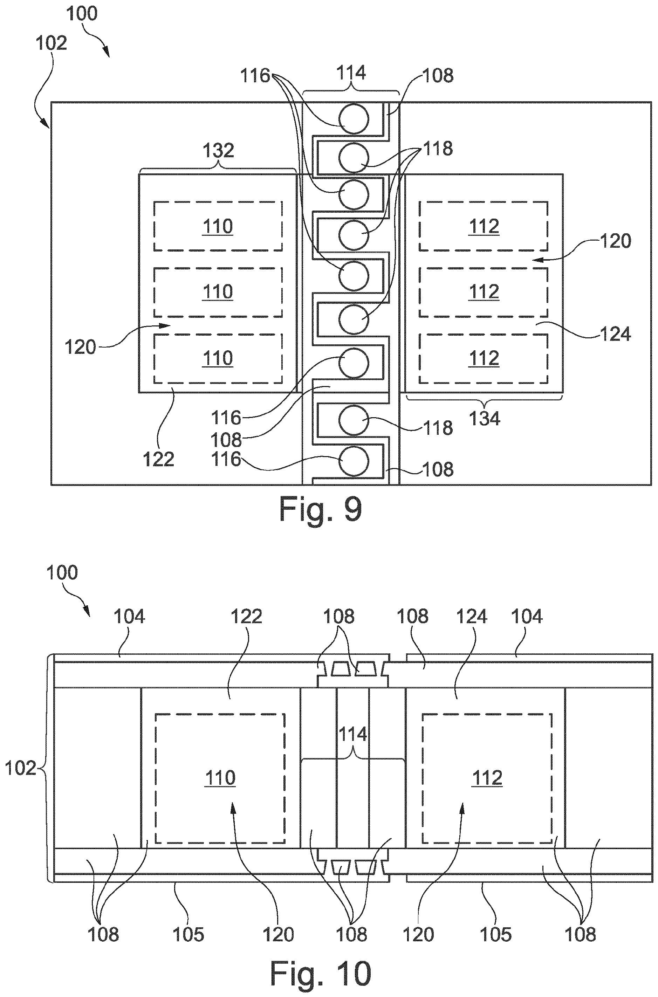

Figure 9 illustrates a transparent plan view of a component carrier according to another exemplary embodiment of the invention.
Figure 10 illustrates a cross-sectional view of the component carrier according to Figure 9.

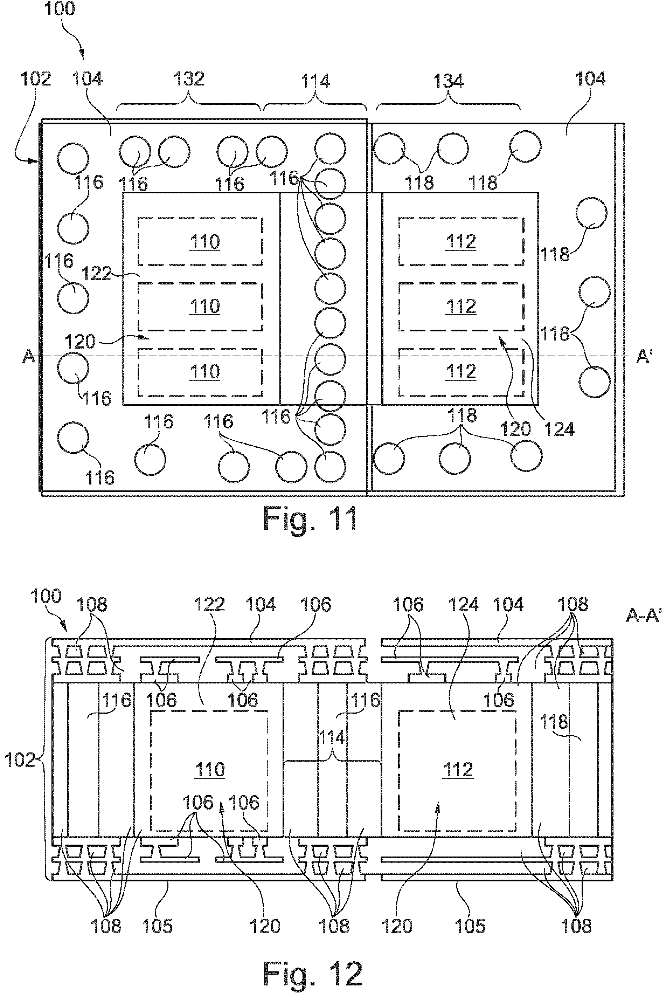

Figure 11 illustrates a transparent plan view of a component carrier according to another exemplary embodiment of the invention.
Figure 12 illustrates a cross-sectional view of the component carrier according to Figure 11.
Figure 13 illustrates a transparent plan view of a component carrier according to another exemplary embodiment of the invention.

The illustrations in the drawings are schematic. In different drawings, similar or identical elements are provided with the same reference signs.

When surface mounting components on and/or embedding components in a component carrier such as a PCB, there may be conventionally issues with crosstalk between different adjacent components from a respective component with each other. For example, embedded components may have respective wires adjacent close to each other, in particular between different embedded high-frequency components. Such components may be sensitive to electromagnetic radiation. Noise, crosstalk and/or other phenomena may thus conventionally reduce the performance and reliability of a component carrier.

According to an exemplary embodiment, a component carrier (for example a PCB or an IC substrate) is provided with a (preferably laminated) layer stack comprising at least an electrically conductive layer structure and an electrically insulating layer structure. Two or more components (at least one of which may be a high-frequency component or a component being sensitive with respect to high-frequency electromagnetic radiation) may be arranged laterally adjacent to each other but with a space in between on and/or in the layer stack. Two at least partially electrically conductive vertical partitioning structures may be positioned at least partially in said space to thereby decouple (for example electromagnetically) the components from each other or shield (for example electromagnetically) the components with respect to each other. Each vertical partitioning structure may circumferentially surround an assigned one of the components along at least part of a component perimeter. By a functional and/or structural interaction, such as an interconnection, between the vertical partitioning structures and at least one electrically conductive layer structure of the stack, it may be possible to efficiently and reliably shield the components with respect to each other and/or with respect to an electronic environment. In particular, undesired transmission of electromagnetic radiation (in particular stray radiation) from at least one of the components and/or to at least one of the components may be suppressed or eliminated. Advantageously, the first vertical partitioning structure and the second vertical partitioning structure may be mutually disconnected at least in a shielding region. At least part of said shielding region may include at least part of the above mentioned space. During operation, the components and/or wiring structures of the component carrier may provide or contribute to noise and/or other undesired phenomena in the component carrier. By disconnecting the first vertical partitioning structure and the second vertical partitioning structure from each other in the shielding region, the vertical partitioning structures may be prevented from being disturbed by noise and/or other undesired phenomena. Hence, disconnecting (such as keeping separated) the first and second vertical partitioning structures in the shielding region may reduce noise and/or may suppress crosstalk. Advantageously, electric signals in the component carrier may consequently experience less noise and/or less other parasitic phenomena, so that an improved signal quality may be achieved.

Apart from the shielding region, it is optionally possible to connect first and second vertical interconnect structures, for example at a common electric ground structure. Alternatively, the first and second vertical interconnection structures may remain disconnected also apart from the shielding region.

Advantageously, exemplary embodiments of the invention may enable electromagnetic interference (EMI) shielding in a multi-cavity package-type component carrier with two or more electronic components. This may be particularly advantageous for applications requiring electromagnetic compatibility (EMC) and/or being sensitive to electromagnetic interference (EMI). According to an exemplary embodiment, it may be possible to shield electronics from emitting electromagnetic radiation and/or to be exposed to electromagnetic radiation. Advantageously, a manufacturing architecture according to exemplary embodiments relates to a process which may be fully compatible with a well-established material and construction flow. Thus, manufacture of component carriers with reasonable effort may be possible. Furthermore, it may be possible according to exemplary embodiments to accomplish a high degree of flexibility in the design of vertical partitioning structures (in embedding and for component placement on a substrate) which may allow for instance to provide a customized integrated Faraday cage in a component carrier. Moreover, exemplary embodiments may enable the embedding of analog and digital components or devices into the same component carrier (such as a substrate) and in dedicated separate cavities being located close to each other.

In an embodiment, it may be possible to place a series of metallized mechanical through holes and/or metallized laser vias connecting ground planes and surrounding active components or devices for avoiding emission and/or influence of electromagnetic radiation from other devices or in the propagation of generated electromagnetic radiation in influencing other devices. In particular, exemplary embodiments may enable a separation between digital and analog domains in the same (for instance substrate-type) component carrier. For instance, a first of the two (or more) components may be a digital component and a second of the two (or more) components may be an analog component.

Exemplary embodiments of the invention may enable the construction of full Faraday's cages (in particular formed by the first and second vertical partitioning structures and preferably in addition formed by one or more of the at least one electrically conductive layer structure of the stack). Advantageously, this may be accomplished within the normal production flow of substrates with embedding components. Beneficially, a component carrier according to exemplary embodiments may provide EMI isolation within a multilayer core or into a two layers core associated with build-up layers carrying metal planes to form six sides of an enclosure.

Further advantageously, a component carrier according to an exemplary embodiment may comprise connections through laser vias with a simple configuration. This may allow to achieve an isolation between cavities protecting even very sensitive devices embedded into the same substrate. Additionally or alternatively, an isolation from and/or to circuits in build-up layers may be achieved as well. Moreover, exemplary embodiments may avoid to have full metalized edges in the package-type component carrier, in particular when critical functions are already protected in the substrate.

Exemplary applications of exemplary embodiments of the invention relate to electronics being sensitive to electromagnetic interference. Exemplary embodiments may be applied particularly advantageously to applications involving the transmission of electromagnetic radiation at frequencies above 100 kHz. At frequencies above 1 GHz, the electromagnetic shielding functionality of the vertical partitioning structures according to exemplary embodiments may be of utmost advantage.

In an embodiment, a component carrier may be provided which enables EMI shielding and integration of analog and digital parts together on the same substrate. This may be particularly advantageous for high frequency packages based on 5G or 6G. Also component carriers providing or contributing to a radar function may be equipped advantageously with vertical partitioning structures in combination with horizontal electrically conductive layer structures according to exemplary embodiments of the invention.

An exemplary idea behind separating ground planes in component carrier technology is to keep digital signals and analog signals separate. For example, if the return current from a digital signal travels near an analog interconnect, the changing edge of the digital signal may generate a magnetic field that can create inductive crosstalk in an analog interconnect, and vice versa. By splitting the ground plane into two totally different sections, a very high isolation between the analog and digital sections is created, so the two types of signals may be reliably protected from interfering or coupling.

A critical design criterion may be that using two physically split ground planes may be acceptable when there are no traces connecting the two sections and when no signals are sent between the two sections, since the return currents may become an issue. The two sections may be entirely isolated and may have no back and forth interaction with each other. This means there may be two components or devices that are completely isolated from each other, in particular one analog component and one digital component. If no traces are routed between the corresponding two regions, then these may be totally isolated devices. With the architecture of the vertical partitioning structures each surrounding at least one respective component and both interacting with one or more electrically conductive layer structures of the layer stack, excellent shielding of the components may be achieved, in particular when disconnecting the vertical partitioning structures selectively in a shielding region in which the shielding effect is dominant.

According to an exemplary embodiment of the invention, a component carrier is provided which comprises a stack comprising at least one insulating layer structure, at least one conductive layer structure and at least two side-by-side components divided by a space. At least one first vertical partitioning conductive structure and at least one second vertical partitioning conductive structure may be provided and may be configured, in a plan view, to at least partially separately encircle each of the at least two side-by-side components. Moreover, said at least one first vertical partitioning conductive structure and said at least one second vertical partitioning conductive structure may interact with said at least one conductive layer structure to be disconnected one to each other.

Next, exemplary embodiments of the components will be explained, which may be inserted in a cavity of the stack. One component may be arranged in a first cavity, whereas the other component may be arranged in a second cavity. For example, the space may comprise or may be filled with insulating material of the stack between the first and the second cavity. In an embodiment, the first and second cavities may be provided in at least one common layer structure of the stack. For instance, the first and second cavities may be provided in the same common layer structures of the stack. In an embodiment, the multiple components may be arranged in one or both cavities. For example, the vertical partitioning conductive structures may be embedded in the stack.

In the following, further embodiments of surface mounted components will be explained: For example, both components may be provided on a common surface of one of the layer structures of the stack. In an embodiment, multiple components may be arranged on the same side of the space. For instance, the vertical partitioning conductive structures may extend through the space and/or beside one of the at least two side-by-side components. In an embodiment, the vertical partitioning conductive structures may be provided on the common surface.

Next, further exemplary embodiments concerning the layout of the vertical partitioning conductive structures will be described: For example, material of the vertical partitioning conductive structures may be inserted in (in particular through) holes and/or vias. In an embodiment, (in particular through) walls from trenches may be filled with material of the vertical partitioning conductive structures. For instance, the vertical partitioning conductive structures may comprise or consist of vertical conductive electrodes, pillars and/or other bodies. The vertical partitioning conductive structures may, in an embodiment, be provided with a regular, irregular, circular, polyhedral, and/or elongated planar shape. For instance, each one of the vertical partitioning conductive structures may comprise a continuous wall. For example, each one of the vertical partitioning conductive structures may comprise a discontinuous wall. In an embodiment, each or at least one vertical partitioning conductive structure may comprise multiple sub-structures (for example multiple holes and/or vias) connected one to each other, in particular through the at least one conductive layer structure. For instance, one or both of the first and the second vertical partitioning conductive structures may completely encircle one of the at least two side-by-side components. In an embodiment, one or both of the first and the second vertical partitioning conductive structures may encircle all the components at the same cavity-side of the space. For example, one of the first or the second vertical partitioning conductive structures may partially encircle one of the at least two side-by-side components. In an embodiment, one or both of the first and the second vertical partitioning conductive structures may partially encircle all the components at the same cavity-side of the space. For instance, at least some of sub-structures of the first vertical partitioning conductive structure are alternatively positioned beside at least one or some of sub-structures of second vertical partitioning conductive structure along a space planar direction. For example, at least some of sub-structures of the first vertical partitioning conductive structure are positioned along a first planar row or in a linear pattern, at least some of sub-structures of the second vertical partitioning conductive structure are positioned along a second planar row or in a linear pattern. In particular, said first planar row or linear pattern may be distributed along a direction parallel to the direction in which the second planar row or linear pattern is distributed. For instance, the first planar row or linear pattern and said second planar row or linear pattern may each or both define a matrix of sub-structures. In an embodiment, sub-structures of the first vertical partitioning conductive structure may be arranged at one side, in particular at the side of one of the at least two components. For example, sub-structures of the second vertical partitioning conductive structure may be located at the opposed side, in particular at the side of the other one of the at least two components. At least part of the electrically conductive layer structure connecting the sub-structures of the first vertical partitioning conductive structure and at least part of electrically conductive layer structures connecting sub-structures of the second vertical partitioning conductive structure may extend along the same vertical position in the stack. At least part of an electrically conductive layer structure connecting the sub-structures of the first vertical partitioning conductive structure may extend above (preferably continuously) one of the at least two components. At least part of the electrically conductive layer structure connecting the sub-structures of the second vertical partitioning conductive structure may extend above (preferably continuously) the other one of the at least two components. In an embodiment, a further electrically conductive layer structure is connected to the sub-structures of the first vertical partitioning conductive structure on the opposed side of the electrically conductive layer structure connecting the sub-structures of the first vertical partitioning conductive structure. For example, a further electrically conductive layer structure is connected to the sub-structures of the second vertical partitioning conductive structure on the opposed side of the electrically conductive layer structure connecting the sub-structures of the second vertical partitioning conductive structure. Said electrically conductive layer structure may extend above (preferably continuously) one of the at least two components. At least part of an electrically conductive layer structure connecting the sub-structures of the first vertical partitioning conductive structure is planarly misaligned with respect to the part of electrically conductive layer structures connecting the sub-structures of the second vertical partitioning conductive structure. At least part of an electrically conductive layer structure connecting the sub-structures of the first vertical partitioning conductive structure may have a different planar extension with respect to the at least part of the electrically conductive layer structure connecting the sub-structures of the second vertical partitioning conductive structure. For example, the at least one first and the at least one second vertical partitioning conductive structures are disconnected one to each other at the planar vertical extension of the first and/or the second vertical partitioning conductive structure. For instance, the at least one first and at least one second vertical partitioning conductive structures are connected one to each other through the electrically conductive layer structures in the component carrier outside the space defined by the first and/or the second vertical partitioning conductive structure and the respective electrically conductive layer structure (and optionally further electrically conductive layer structure). In an embodiment, the at least one first vertical partitioning conductive structure and/or the at least one second vertical partitioning conductive structure may comprise an (in particular electrically) conductive structure and/or pad at one or at both vertical extremities. For instance, each one of the sub-structures of the at least one first vertical partitioning conductive structure and/or the at least one second vertical partitioning conductive structure comprises an (in particular electrically) conductive structure and/or pad at one or at both vertical extremities. For example, a plurality of first vertical partitioning conductive structures and/or a plurality of second vertical partitioning conductive structures are connected at one or both extremities by an electrically conductive structure, for example with a loop shape. In an embodiment, the loop shaped structure is connected to the at least one conductive layer structure interacting with the first or the second vertical partitioning unit, for example through vias. For instance, the components are connected to a further electrically conductive layer structure. Said further electrically conductive layer structure may be vertically provided between the respective component and the at least one conductive layer structure interacting with the first or the second vertical partitioning unit and/or may be distanced from the at least one conductive layer structure interacting with the first or the second vertical partitioning unit. In an embodiment, the further electrically conductive layer structure is not connected to the at least one conductive layer structure. For instance, the at least one conductive layer structure may be connected to said conductive structure or pad, in particular through vias.

Next, a distribution of different domains in the component carrier will be described: In an embodiment, said first and said second vertical partitioning conductive structures are associated to first and second domains, respectively. In particular, said first component and said second component may be associated to a first and a second domain, respectively. For example, the plurality of components on one side of the space are associated to the same domain. In an embodiment, the vertical partitioning conductive sub-structure closer to the respective component is associated (for instance grounded, but closer to the component(s) belonging to the specific domain) to the same domain of said component. At least part of the electrically conductive layer structure closer to the respective component is associated to the same domain of said component. For example, such domains may be analog and digital domains, power and signal domains, and/or other domains.

According to a preferred embodiment, it may be possible to define a Faraday cage within the construction of a multi-cavity package-type component carrier with an electromagnetic isolation between adjacent cavities in which different electronic components may be embedded. Advantageously, this may be accomplished by through plated mechanical through holes in a separating dam forming vertical partitioning structures. More specifically, it may be possible to form an embedded Faraday cage in an embedded core and establish a connection with build-up layers. Advantageously, this may lead to an efficient EMI shielding of the electronic components. Thus, an efficient EMI protection of electronic components of a component carrier may be made possible by creating a Faraday cage between two or more closely embedded components. This may be accomplished by a dam filled with mechanical through holes which can form vertical partitioning structures. Said vertical partitioning structures may form electrically conductive fences each surrounding a respective component or a respective group of components. Each fence may be formed by an array of mutually spaced vertical elements of the respective vertical partitioning structure. Such vertical elements of a respective fence may surround, for instance along a rectangular pattern, the respective component. Elements of the first vertical partitioning structure and elements of the second vertical partitioning structure may be disconnected in the space between the component or in the Faraday cage region, but may be connected with each other outside of said shielding region, for instance at a common reference potential structure (such as a common ground potential structure) of the component carrier. This may have advantageous effects: components or devices can inject noise in ground lines, and if not disconnected, elements of the first and second vertical partitioning structures assigned to the different components would be usually disturbed by noise. When disconnecting said elements of the first and second vertical partitioning structures in the Faraday cage region, there may be however less noise and crosstalk.

For example, a two-stage shielding of components of a component carrier arranged side-by-side may be established: A first shielding stage may be realized by grouping a first group of components (for instance only analog components) which are each shielded collectively or individually by a first vertical partitioning structure. A second shielding stage may be realized by grouping a second group of components (for instance only digital components) which are each shielded collectively or individually by a second vertical partitioning structure. A shielding dam may be arranged in a space between the first group and the second group of components and may be formed by elements of the first conductive vertical partitioning structure and/or the second vertical conductive partitioning structure, which may for instance be embedded in electrically insulating material of at least one electrically insulating layer structure of the stack.

**Figure 1** illustrates a transparent plan view of a component carrier 100 according to an exemplary embodiment of the invention. **Figure 2** illustrates a cross-sectional view of the component carrier 100 according to Figure 1.

Component carrier 100 may be an integrated circuit (IC) substrate or a printed circuit board (PCB). The component carrier 100 may comprise a laminated layer stack 102 comprising electrically conductive layer structures 104, 105 and electrically insulating layer structures 108. For example, the electrically conductive layer structures 104, 105 may comprise patterned metal layers (such as patterned copper foils or patterned deposited copper layers) and vertical through connections, for example copper filled vias, which may be created by drilling and plating. The electrically insulating layer structures 108 may comprise a respective resin (such as a respective epoxy resin), preferably comprising reinforcing particles therein (for instance glass fibers or glass spheres). For example, the electrically insulating layer structures 108 may be made of prepreg or FR4. The electrically insulating layer structures 108 may also comprise resin layers being free of glass (in particular glass fibers).

As best seen in Figure 1, component carrier 100 comprises a group of first components 110 and a group of second components 112 which are all embedded in the stack 102. During a process of manufacturing component carrier 100 according to Figure 1 and Figure 2, the first components 110 are arranged in a first cavity 122 of the stack 102. Furthermore, the second components 112 are arranged in a separate second cavity 124 of the stack 102. The first components 110 may be arranged side-by-side at the same vertical level in the first cavity 122. The second components 112 may be arranged side-by-side at the same vertical level in the second cavity 124. The first cavity 122 and the second cavity 124 may be formed in one of more common of said layer structures 104, 105, 108 of the stack 102. Thus, several (for example three) first components 110 are arranged in the first cavity 122 and several (for example three) second components 112 are arranged in the second cavity 124. In the configuration according to Figure 1, a first vertical partitioning structure 116 (described below in detail) completely surrounds all first components 110 arranged at one common side of a space 114 and all being arranged in common cavity 122. Accordingly, a second vertical partitioning structure 118 (described below in detail) completely surrounds all second components 112 arranged at one other common side of the space 114 and are all arranged in the other common cavity 124.

For instance, the components 110, 112 may be semiconductor chips. For example, the first components 110 may be digital components, whereas the second components 112 may be analog components. The first components 110 of a digital domain are arranged on the same side of said space 114, i.e. on the left-hand side. Correspondingly, the second components 112 of an analog domain are arranged on another same side of said space 114, i.e. on the right-hand side. Thus, the arrangement of Figure 1 and Figure 2 ensures that the digital domain and the analog domain of component carrier 100 are spatially separated. For example, the analog domain of second components 112 may relate a sensing side of the component carrier 100. The digital domain corresponding to first components 110 may relate to a computational side of the component carrier 100. An exemplary electronic application of the component carrier 100 with its components 110, 112 may be an analog-to-digital converter (ADC) or a digital-to-analog converter (DAC). Possible applications with digital and analog components are mobile communication, radar applications, etc. In these and other applications, it may be desired to have no or at least no excessive electromagnetic interaction between the analog side and the digital side so that it may be desired to suppress electromagnetic interference (EMI) between the analog side and the digital side.

More generally, the first vertical partitioning structure 116 with its first components 110 may be associated to a first electrical domain 132 (in the present embodiment a digital domain) and said second vertical partitioning structure 118 with its second components 112 may be associated to another second electrical domain 134 (in the present embodiment an analog domain). In the shown embodiment, the first electrical domain 132 may be a digital domain, whereas the second electrical domain 134 may be an analog domain. By the below described configuration of the vertical partitioning structures 116, 118 it may be possible to combine domains or technologies for which a combination is challenging but feasible with a shielding function provided by the vertical partitioning structures 116, 118.

The first components 110 on one side of said space 114 may thus be associated to the first electrical domain 132 and the second components 112 on the other side of said space 114 are associated to the second electrical domain 134. The first vertical partitioning structure 116, which is located closer to the first components 110 than the second vertical partitioning structure 118 is associated to the same electrical domain 132 as said first components 110. Accordingly, the second vertical partitioning structure 118 which is located closer to the second components 112 than the first vertical partitioning structure 116 is associated to the same electrical domain 134 as said second components 112. In the same way, a respective part or portion of said electrically conductive layer structures 104, 105 which is located closer to the first components 110 than to said second components 112 is associated to the same electrical domain 132 as said first components 110. And another part or portion of said electrically conductive layer structures 104, 105 which is located closer to the second components 112 than to said first components 110 is associated to the same electrical domain 134 as said second components 112.

As shown in Figure 1, the first components 110 on the one hand and the second components 112 on the other hand are arranged side-by-side, i.e. in the shown embodiment laterally juxtaposed, and are divided or spatially separated by space 114 located in between. Said space 114 is partially filled with electrically insulating material of the electrically insulating layer structures 108 of the stack 102 between the first cavity 122 and the second cavity 124. In addition, said space 114 is filled with metallic material of vertical pillars of first and second vertical partitioning structures 116, 118 (described below in further detail).

At least some of the components 110, 112 may transmit, receive and/or process radiofrequency signals or waves. It is also possible that at least some of the components 110, 112 are sensitive with respect to radiofrequency radiation, for instance are disturbed or negatively influenced by radiofrequency radiation. In view of the foregoing, it may be advantageous to separate at least the first components 110 from the second components 112 electromagnetically. This is accomplished by the arrangement of the components 110, 112 separated by space 114 and by the configuration of vertical partitioning structures 116, 118 cooperating with electrically conductive layer structures 104, 105 in the way as described in the following:
Stack 102 comprises the already mentioned electrically conductive first vertical partitioning structure 116 and the electrically conductive second vertical partitioning structure 118. The first vertical partitioning structure 116 and the second vertical partitioning structure 118 are both fully embedded in the stack 102. Each of said first and second vertical partitioning structures 116, 118 is formed by a plurality of vertically extending metallic pillars (preferably made of copper) which have a circular cross-section in the embodiment of Figure 1 and Figure 2, but may have any other shape as well. As best seen in Figure 1, the metallic pillars of the first vertical partitioning structure 116 are arranged in a rectangular pattern to surround the group of first components 110. Correspondingly, the metallic pillars of the second vertical partitioning structure 118 are arranged in a rectangular pattern to surround the group of second components 112. A subgroup of the metallic pillars of both vertical partitioning structures 116, 118 are arranged side-by-side in the space 114. Thus, a part of the metallic pillars of the vertical partitioning structures 116, 118 is arranged in said space 114 parallel to each other and in parallel arrays so as to extend in a linear fashion along one side of the respectively assigned group of components 110, 112. Another part of the metallic pillars of the vertical partitioning structures 116, 118 is arranged apart from the space 114 and surrounds, in the plan view of Figure 1, three other sides of the respective group of components 110, 112. Consequently, the group of first components 110 is surrounded circumferentially by a fence of said parallel and vertically extending metallic pillars of the first vertical partitioning structure 116. Correspondingly, the group of second components 112 is surrounded circumferentially by a fence of said parallel and vertically extending metallic pillars of the second vertical partitioning structure 118. In a plan view on the stack 102 as shown in Figure 1, each of the vertical partitioning structures 116, 118, surrounds assigned ones of the components 110, 112. The first vertical partitioning structure 116 separately surrounds the group of first components 110 in the plan view. Accordingly, the second vertical partitioning structure 118 separately surrounds the group of second components 112 in the plan view. Some of the metal pillars of the first vertical partitioning structure 116 and some of the metal pillars of the second vertical partitioning structure 118 extend through the space 114 and besides the components 110, 112.

In the space 114, a metallic dam formed by a first column of metallic pillars of the first vertical partitioning structure 116 and by a parallel second column of metallic pillars of the second vertical partitioning structure 118 electromagnetically shields the group of first components 110 with respect to the group of second components 112. As shown, some of the metal-pillar type sub-structures of the first vertical partitioning structure 116 are arranged along a first linear pattern and some of the metal-pillar type sub-structures of the second vertical partitioning structure 118 are arranged along a second linear pattern. Said first linear pattern extends along a direction parallel to a direction along which the second linear pattern extends. Thus, a first fence side of parallel metallic pillars of the first vertical partitioning structure 116 and a second fence side of parallel metallic pillars of the second vertical partitioning structure 118 are arranged between the group of first components 110 and the group of second components 112. Said first fence side and said second fence side extend parallel to each other. With the described fence structure, the first vertical partitioning structure 116 and the second vertical partitioning structure 118 form a discontinuous wall along each side of the group of first components 110 and the group of second components 112, respectively. This may provide a highly efficient electromagnetic decoupling of the group of first components 110 with respect to the group of second components 112, which may lead to a highly efficient EMI protection.

For providing a further improved protection of the components 110, 112 against electromagnetic stray radiation or the like, it is advantageous that the first vertical partitioning structure 116 and the second vertical partitioning structure 118 are arranged to interact with electrically conductive layer structure 104 on the top side of the stack 102 and with electrically conductive layer structure 105 on the bottom side of the stack 102 for shielding the components 110, 112. As can be taken from Figure 2, each of the first vertical partitioning structure 116 and the second vertical partitioning structure 118 comprises respective electrically conductive pads 126 at both vertical extremities. More specifically, each of the sub-structures in form of metal pillars of the first vertical partitioning structure 116 and the second vertical partitioning structure 118 comprises such an electrically conductive pad 126 at both vertical extremities. Electrically conductive layer structures 104, 105 are connected to said planar pads 126 by a plurality of electrically conductive vias 128. The latter may be copper-filled laser vias.

The first vertical partitioning structure 116 and the second vertical partitioning structure 118 may be disconnected from each other in a shielding region 120 around said components 110, 112. More specifically, the first vertical partitioning structure 116 and the second vertical partitioning structure 118 are disconnected from each other at or along an entire vertical extension of the first vertical partitioning structure 116 and the second vertical partitioning structure 118. Although not shown in Figure 1 and Figure 2, the first vertical partitioning structure 116 and the second vertical partitioning structure 118 may be coupled with each other through another electrically conductive layer structure of the stack 102 outside a region defined by the first vertical partitioning structure 116 and the second vertical partitioning structure 118 as well as said electrically conductive layer structures 104, 105. For instance, such a connection may be established at a ground line of the component carrier 100, at a reference potential pad, etc. (not shown).

As shown in Figure 1 and Figure 2, the uppermost electrically conductive layer structure 104 may be subdivided into different mutually decoupled sections, one connected to the first vertical partitioning structure 116 and the other connected to the second vertical partitioning structure 118. For example, the section of the electrically conductive layer structure 104 connected to the first vertical partitioning structure 116 may provide the functionality of a digital ground 170. For instance, the other section of the electrically conductive layer structure 104 connected to the second vertical partitioning structure 118 may provide the functionality of an analog ground 172. Furthermore, a block shown with reference sign 174 and including space 114 may ensure domain separation and EMI shielding. Further blocks 176, 178 may also contribute to EMI shielding. Moreover, lowermost electrically conductive layer structure 105 of stack 102 is also connected to the first vertical partitioning structure 116 on a vertically opposing side than said electrically conductive layer structure 104, so that the first components 110 are shielded from above and below by said electrically conductive layer structures 104, 105. Correspondingly, another portion of the electrically conductive layer structure 105 is connected to the second vertical partitioning structure 118 on the vertically opposing side than said electrically conductive layer structure 104, so that also the second components 112 are shielded from above and below by said electrically conductive layer structures 104, 105. Again referring to Figure 2, the lowermost electrically conductive layer structure 105 may be subdivided into different mutually decoupled sections, one connected to the first vertical partitioning structure 116 and the other connected to the second vertical partitioning structure 118.

Each of the first vertical partitioning structure 116 and the second vertical partitioning structure 118 comprises multiple sub-structures in form of the metallic pillars which are connected with each other by the electrically conductive layer structures 104, 105. The section of electrically conductive layer structure 104 connecting sub-structures of the first vertical partitioning structure 116 and another section of the electrically conductive layer structure 104 connecting sub-structures of the second vertical partitioning structure 118 extend along the same vertical level in the stack 102 and may be separated. They may form part of a common planar patterned metal layer. Correspondingly, the section of electrically conductive layer structure 105 connecting sub-structures of the first vertical partitioning structure 116 and another section of the electrically conductive layer structure 105 connecting sub-structures of the second vertical partitioning structure 118 extend along the same vertical level in the stack 102 and may be separated. They may form part of another common planar patterned metal layer. The portion of the electrically conductive layer structure 104 connecting sub-structures of the first vertical partitioning structure 116 extends above and continuously over the upper main surface of the first components 110. The portion of the electrically conductive layer structure 105 connecting sub-structures of the first vertical partitioning structure 116 extends below and continuously over the lower main surface of the first components 110. The other portion of the electrically conductive layer structure 104 connecting sub-structures of the second vertical partitioning structure 118 extends above and continuously over the upper main surface of the second components 112. The other portion of the electrically conductive layer structure 105 connecting sub-structures of the second vertical partitioning structure 118 extends below and continuously over the lower main surface of the second components 112. The section or part of the electrically conductive layer structure 104 connecting a top side of the first vertical partitioning structure 116 may have a different (or the same) planar extension than (or as) the other part of said electrically conductive layer structure 104 connecting a top side of the second vertical partitioning structure 118. Correspondingly, the section or part of the other electrically conductive layer structure 105 connecting a bottom side of the first vertical partitioning structure 116 may have a different (or the same) planar extension than (or as) the other part of said other electrically conductive layer structure 105 connecting a bottom side of the second vertical partitioning structure 118.

By the metal pillars of the first vertical partitioning structure 116 and the correspondingly connected sections of the electrically conductive layer structures 104, 105, the first components 110 are arranged in a Faraday cage. Correspondingly, also the second components 112 are arranged in a further separate Faraday cage by the metal pillars of the second vertical partitioning structure 118 and the correspondingly connected sections of the electrically conductive layer structures 104, 105. This may ensure a reliable electromagnetic decoupling between the first components 110 and the second components 112. Descriptively speaking, electrically conductive layer structures 104, 105 function as shielding planes for the components 110, 112, whereas the metal pillars of the vertical partitioning structures 116, 118 function as shielding fences. The shielding planes and corresponding shielding fences may be interconnected.

A distance between adjacent sub-structures of the vertical partitioning structures 116, 118 may be smaller in the space 114 than in other regions of the vertical partitioning structures 116, 118 surrounding components 110, 112. There may be a shift to interstitial coordinates positioning of the sub-structures (in particular mechanical through holes filled with metallic material) at same pitch. There may be a denser electromagnetic shielding between domains 132, 134 compared to an intra-domain pitch. The distance between the respective members or sub-structures of the vertical partitioning structures 116, 118 may be dependent on the frequency of the application. Moreover, the distance between the respective members or sub-structures of the first vertical partitioning structures 116 may be different from the distance between the respective members or sub-structures of the second vertical partitioning structures 118.

**Figure 3** illustrates a cross-sectional view of a component carrier 100 similar to that according to Figure 1.

The embodiment of Figure 3 differs from the embodiment of Figure 1 and Figure 2 in particular in that, according to Figure 3, stack 102 has an additional build-up 150, 152 at both opposing main surfaces. Said build-ups 150, 152 may comprise one or more further electrically insulating layer structures 108 and one or more further electrically conductive layer structures, which may be configured in a similar way as described according to Figure 2. The additional build-ups 150, 152 may be formed in accordance with a specific application.

**Figure 4** illustrates a transparent plan view of a component carrier 100 according to another exemplary embodiment of the invention.

The embodiment of Figure 4 differs from the embodiment of Figure 1 in particular in that, according to Figure 4, the sub-structures (such as metal pillars) of the first vertical partitioning structure 116 extend only along one side of the first components 110 and therefore surround them only partially. However, the first vertical partitioning structure 116 extends beyond the upper and the lower end of said side of the cavity 122, as shown in Figure 4. This may extend the shielding effect. Correspondingly, the sub-structures (such as metal pillars) of the second vertical partitioning structure 118 extend only along one side of the second components 112 and therefore surround them only partially. This renders the component carrier 100 more compact. However, also the second vertical partitioning structure 118 extends beyond the upper and the lower end of said side of the cavity 124, as shown in Figure 4. This may extend the shielding effect.

**Figure 5** illustrates a plan view (illustration on the top side) and a cross-sectional view (illustration on the bottom side) of a component carrier 100 according to another exemplary embodiment of the invention.

In the embodiment of Figure 5, first and second vertical partitioning structures 116, 118 are connected at a bottom sided extremity by an electrically conductive coupling structure 130 arranged in a loop shape. Said loop shaped coupling structure 130 is connected to the electrically conductive layer structure 104 interacting with the first and second vertical partitioning structures 116, 118 through pads 126 and vias 128. The loop shaped coupling structure 130 may form part of electrically conductive layer structure 105 described above.

Furthermore, the components 110, 112 are connected to an additional electrically conductive layer structure 106 of the stack 102. Said additional electrically conductive layer structure 106 may be arranged at least partially vertically between the components 110, 112 and said electrically conductive layer structure 104 interacting with the first and second vertical partitioning structures 116, 118. Moreover, said additional electrically conductive layer structure 106 may be at least partially spaced and may be electrically decoupled from said electrically conductive layer structure 104 interacting with the first and second vertical partitioning structures 116, 118. Thus, the additional electrically conductive layer structure 106 is not connected to said electrically conductive layer structure 104. In the shown embodiment, the additional electrically conductive layer structure 106 comprises a planar array of frustoconical structures formed by laser drilling and plating, i.e. vias.

In the illustrated arrangement, components 110, 112 may emit electromagnetic radiation 160 which is shielded by the Faraday cage like arrangement of vertical partitioning structures 116, 118 and interconnected electrically conductive layer structures 104, 105. Consequently, said electromagnetic radiation 160 can be prevented from disturbing other components 110, 112, 158 and an electronic environment. Furthermore, it may also be possible that electromagnetic radiation 160 from an electronic environment of the component carrier 100 is shielded by the Faraday cage like arrangement of vertical partitioning structures 116, 118 and interconnected electrically conductive layer structures 104, 105. Consequently, said electromagnetic radiation 160 can be prevented from disturbing the components 110, 112, 158.

Regardless of the Faraday cage like arrangement surrounding all six sides of the components 110, 112, additional electrically conductive layer structure 106 being electrically decoupled from said Faraday cage like arrangement may allow to transmit signals from the electronic components 110, 112, 158 to other portions of the component carrier 100 and/or to an electronic environment of the component carrier 100, and/or in opposite direction. Said electric signals (for example high-frequency signals) may be guided by the additional electrically conductive structure 106 through the electrically conductive layer structure 104 with an annular insulating gap 162 of an electrically insulating layer structure 108 in between. A width, d, of said annular insulating gap 162 may for instance be in a range from 5 µm to 100 µm, in particular 10 µm to 50 µm. To put it shortly, electric signals may be guided through the Faraday cage by vias of the additional electrically conductive layer structure 106.

**Figure 6** illustrates a plan view and a cross-sectional view of a component carrier 100 according to another exemplary embodiment of the invention. The upper image of Figure 6 shows the plan view and a line A-A'. The lower image of Figure 6 shows the cross-sectional view along line A-A'.

Component carrier 100 according to Figure 6 is similar to component carrier 100 according to Figure 5. Figure 6 shows that the principle of Figure 5 can be further refined and extended.

**Figure 7** illustrates a transparent plan view of a component carrier 100 according to another exemplary embodiment of the invention. **Figure 8** illustrates a cross-sectional view of the component carrier 100 according to Figure 7. Figure 7 shows the plan view and a line A-A'. Figure 8 shows the cross-sectional view along line A-A'.

The embodiment of Figure 7 and Figure 8 differs from the embodiment of Figure 4 in particular in that, according to Figure 7 and Figure 8, the sub-structures (i.e. the metal pillars) of the first vertical partitioning structure 116 and of the second vertical partitioning structure 118 are alternatively positioned along a shielded side of components 110, 112. In this embodiment, vertical partitioning structures 116, 118 are arranged along a single common straight line in the space 114 between the cavity 122 accommodating the first components 110 and the cavity 124 accommodating the second components 112. Along said single common straight line, a metal pillar of the first vertical partitioning structure 116 is followed by a metal pillar of the second vertical partitioning structure 118, which is followed by a metal pillar of the first vertical partitioning structure 116, which is followed by a metal pillar of the second vertical partitioning structure 118, and so on. This combines reliable shielding with a highly compact design.

While the dimensions of the various constituents of the component carrier 100 according to Figure 7 and Figure 8 may vary over broad ranges, some specific examples for some characteristic dimensions will be given in the following: A horizontal length, L, of a dam between the cavities 122, 124 may be in a range from 300 µm to 700 µm, for example 500 µm. The metal pillars of the vertical partitioning structures 116, 118 may be metal-filled mechanical drill holes with a diameter, D, in a range from 100 µm to 200 µm, for example of 150 µm. Furthermore, a width, B, of a metal bridge in space 114 may be in a range from 300 µm to 500 µm, for example may be a 400 µm copper bridge. In addition, a 125 µm annular ring may be formed. Moreover, a gap, I, between a cavity edge and the metal bridge may be foreseen, which may be in particular in a range from 20 µm to 100 µm, for example 50 µm. Beyond this, a safety distance may be created between cavity edge and a plated through hole, for instance at least 150 µm or at least 250 µm. The mechanical through holes in the cavity dam, which may form the basis of the metal pillars may be provided in a single row (as shown) or in multiple rows. Metal-filled laser vias may be formed for connecting mechanical drill holes to shielding planes. The embodiment of Figure 7 and Figure 8 may enable for instance a separation between a digital and an analog domain in the same component carrier 100, which may be a substrate.

**Figure 9** illustrates a transparent plan view of a component carrier 100 according to another exemplary embodiment of the invention. **Figure 10** illustrates a cross-sectional view of the component carrier 100 according to Figure 9.

The embodiment of Figure 9 and Figure 10 differs from the embodiment of Figure 7 and Figure 8 in particular in that, according to Figure 9 and Figure 10, a meandric line of one or more electrically insulating layer structures 108 is arranged between the sub-structures of the first and second vertical partitioning structures 116, 118 to further strengthen the separation of the different domains 132, 134.

**Figure 11** illustrates a transparent plan view of a component carrier 100 according to another exemplary embodiment of the invention. **Figure 12** illustrates a cross-sectional view of the component carrier 100 according to Figure 11. Figure 11 shows the plan view and a line A-A'. Figure 12 shows the cross-sectional view along line A-A'.

The embodiment of Figure 11 and Figure 12 differs from the embodiment of Figure 1 and Figure 2 in particular in that, according to Figure 11 and Figure 12, only sub-structures (in particular metal pillars) of the first vertical partitioning structure 116 are arranged in the space 114, but no sub-structures (in particular metal pillars) of the second vertical partitioning structure 118. This combines reliable shielding with a highly compact design.

Alternatively, only sub-structures (in particular metal pillars) of the second vertical partitioning structure 118 are arranged in the space 114, but no sub-structures (in particular metal pillars) of the first vertical partitioning structure 116.

**Figure 13** illustrates a transparent plan view of a component carrier 100 according to another exemplary embodiment of the invention.

In the embodiment of Figure 13, the space 114 is not straight (as in other figures), but is arranged between cavity 122 and cavity 124 L-shaped or angled. Also cavity 122 is L-shaped or angled.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), which comprises:
a stack (102) which comprises at least one electrically conductive layer structure (104-106) and at least one electrically insulating layer structure (108);
at least two components (110, 112) arranged on and/or in the stack (102) side-by-side and divided by a space (114); and
at least one electrically conductive first vertical partitioning structure (116) and at least one electrically conductive second vertical partitioning structure (118), wherein at least one of the vertical partitioning structures (116, 118) is arranged at least partially in said space (114) and wherein each of the vertical partitioning structures (116, 118), in a plan view on the stack (102), surrounds at least partially at least one assigned one of the at least two components (110, 112);
wherein said at least one first vertical partitioning structure (116) and said at least one second vertical partitioning structure (118) interact with one of said at least one electrically conductive layer structure (104) for shielding the at least two components (110, 112) and are disconnected from each other in a shielding region (120) around said at least two components (110, 112).

2. The component carrier (100) according to claim 1, wherein one of the at least two components (110, 112) is arranged in a first cavity (122) of the stack (102), and another of the at least two components (110, 112) is arranged in a second cavity (124) of the stack (102), and wherein in particular said space (114) comprises electrically insulating material of the stack (102) between the first cavity (122) and the second cavity (124).

3. The component carrier (100) according to any of claims 1 to 2, wherein a plurality of said components (110) is arranged at one side of the space (114), in particular in the first cavity (122) and/or a plurality of said components (112) is arranged at the opposed side of the space (114), in particular in the second cavity (124).

4. The component carrier (100) according to any of claims 1 to 3, wherein the at least one first vertical partitioning structure (116) and the at least one second vertical partitioning structure (118) are embedded in the stack (102).

5. The component carrier (100) according to any of claims 1 to 4, wherein at least part of the at least one first vertical partitioning structure (116) and/or at least part of the at least one second vertical partitioning structure (118) comprises at least one blind hole, through hole and/or via, in particular filled at least partially with a metallic and/or a magnetic material.

6. The component carrier (100) according to any of claims 1 to 5, wherein at least part of the at least one first vertical partitioning structure (116) and/or at least part of the at least one second vertical partitioning structure (118) comprises at least one wall section or through wall, in particular filled at least partially with a metallic and/or a magnetic material, and/or wherein at least part of the at least one first vertical partitioning structure (116) and/or at least part of the at least one second vertical partitioning structure (118) comprises a vertical electrode and/or a pillar, and/or wherein at least part of the at least one first vertical partitioning structure (116) and/or at least part of the at least one second vertical partitioning structure (118) has a regular shape, an irregular shape, a round shape, a polygonal shape, and/or an elongated planar shape.

7. The component carrier (100) according to any of claims 1 to 6, wherein the at least one first vertical partitioning structure (116) and/or the at least one second vertical partitioning structure (118) comprises multiple sub-structures connected with each other, in particular connected by the one of the at least one electrically conductive layer structure (104).

8. The component carrier (100) according to any of claims 1 to 7, wherein at least some of sub-structures of the at least one first vertical partitioning structure (116) are alternatively positioned between at least some of sub-structures of the at least one second vertical partitioning structure (118).

9. The component carrier (100) according to any of claims 1 to 8, wherein at least some of sub-structures of the at least one first vertical partitioning structure (116) are arranged along a first linear pattern and at least some of sub-structures of the at least one second vertical partitioning structure (118) are arranged along a second linear pattern, in particular said first linear pattern extending along a direction parallel to a direction along which the second linear pattern extends.

10. The component carrier (100) according to any of claims 1 to 9, wherein sub-structures of the at least one first vertical partitioning structure (116) are arranged at one side of said space (114), in particular extending along at least one side of at least one of the at least two components (110) on said side of said space (114).

11. The component carrier (100) according to any of claims 1 to 10, wherein a part of the one of the at least one electrically conductive layer structure (104) connecting sub-structures of the first vertical partitioning structure (116) extends above, preferably continuously, at least one of the at least two components (110, 112), wherein in particular a part of the one of the at least one electrically conductive layer structure (104) connecting sub-structures of the second vertical partitioning structure (118) extends above, preferably continuously, at least one of the at least two components (110, 112).

12. The component carrier (100) according to any of claims 1 to 11, wherein another one of said at least one electrically conductive layer structure (105) is connected to the at least one first vertical partitioning structure (116) on a vertically opposing side than said one of the at least one electrically conductive layer structure (104), so that at least one of the at least two components (110, 112) is shielded from above and below by said one of said at least one electrically conductive layer structure (104) and said other one of said at least one electrically conductive layer structure (105), respectively, wherein in particular said other one of said at least one electrically conductive layer structure (105) is connected to the at least one second vertical partitioning structure (118) on the vertically opposing side than said one of the at least one electrically conductive layer structure (104), so that at least one other of the at least two components (110, 112) is shielded from above and below by said one of said at least one electrically conductive layer structure (104) and said other one of said at least one electrically conductive layer structure (105), respectively.

13. The component carrier (100) according to any of claims 1 to 12, wherein the at least one first vertical partitioning structure (116) and the at least one second vertical partitioning structure (118) are disconnected from each other at a vertical extension of the at least one first vertical partitioning structure (116) and/or the at least one second vertical partitioning structure (118), and/or wherein the at least one first vertical partitioning structure (116) and the at least one second vertical partitioning structure (118) are connected with each other through at least one further of the at least one electrically conductive layer structure outside a region defined by the at least one first vertical partitioning structure (116) and/or the at least one second vertical partitioning structure (118) and said one of said at least one electrically conductive layer structure (104).

14. The component carrier (100) according to any of claims 1 to 13, wherein said at least one first vertical partitioning structure (116) is associated to a first electrical domain (132) and said at least one second vertical partitioning structure (118) is associated to another second electrical domain (134), wherein in particular at least one, in particular a plurality, of said at least two components (110) on one side of said space (114) is associated to the first electrical domain (132) and/or at least one other, in particular another plurality, of said at least two components (112) on the other side of said space (114) is associated to the second electrical domain (134).

15. A method of manufacturing a component carrier (100), wherein the method comprises:
providing a stack (102) which comprises at least one electrically conductive layer structure (104-106) and at least one electrically insulating layer structure (108);
arranging at least two components (110, 112) on and/or in the stack (102) side-by-side and divided by a space (114);
forming at least one electrically conductive first vertical partitioning structure (116) and at least one electrically conductive second vertical partitioning structure (118), wherein at least one of the vertical partitioning structures (116, 118) is arranged at least partially in said space (114), and wherein each of the vertical partitioning structures (116, 118), in a plan view on the stack (102), surrounds at least partially at least one assigned one of the at least two components (110, 112); and
configuring said at least one first vertical partitioning structure (116) and said at least one second vertical partitioning structure (118) to interact with one of said at least one electrically conductive layer structure (104) for shielding the at least two components (110, 112), wherein said at least one first vertical partitioning structure (116) and said at least one second vertical partitioning structure (118) are disconnected from each other in a shielding region (120) around said at least two components (110, 112).
